# EUROPÄISCHE PATENTSCHRIFT

(11) **EP 0 899 797 B1**
(45) Veröffentlichungstag und Bekanntmachung des Hinweises auf die Patenterteilung: **24.11.2004**
(21) Anmeldenummer: 98202821.9
(22) Anmeldetag: 24.08.1998
(51) Int. Cl.: H01L 41/107, H02M 5/00

(54) **Schaltungsanordnung mit einem piezoelektrischen Transformator**
Circuit with a piezoelectric transformer
Circuit avec un transformateur piézo-électrique

(30) Priorität: 28.08.1997 DE 19737472
(43) Veröffentlichungstag der Anmeldung: 03.03.1999
(73) Patentinhaber: Philips Intellectual Property & Standards GmbH, 20099 Hamburg (DE); Koninklijke Philips Electronics N.V., 5621 BA Eindhoven (NL)
(72) Erfinder: Comberg, Albert, Dr., Röntgenstrasse 24, 22335 Hamburg (DE); Porath, Rebekka, Dr., Röntgenstrasse 24, 22335 Hamburg (DE)
(74) Vertreter: Volmer, Georg, Dipl.-Ing.

(56) Entgegenhaltungen:
- DE-A- 3 123 104
- PATENT ABSTRACTS OF JAPAN vol. 95, no. 11, 26. Dezember 1995 (1995-12-26) & JP 07 220888 A (HITACHI METALS)
- PATENT ABSTRACTS OF JAPAN vol. 9, no. 248 (E-347), 4. Oktober 1985 (1985-10-04) & JP 60 098692 A (KUREHA KAGAKU KOGYO)

## Beschreibung

Die Erfindung betrifft eine Schaltungsanordnung mit einem piezoelektrischen Transformator mit zwei an der Primärseite des Transformators angeordneten Elektroden sowie einen solchen piezoelektrischen Transformator selbst.

Piezoelektrische Transformatoren sind bekannte elektrische Bauelemente, die den direkten piezoelektrischen Effekt und gleichzeitig dessen Umkehrung in einem Bauelement ausnutzen. Elektrische Energie wird zunächst auf der Primärseite in mechanische Energie umgewandelt, und diese wird nach interner Übertragung mechanischer Energie von der Primär- auf die Sekundärseite dort wieder in elektrische Energie gewandelt. Ein piezoelektrischer Transformator wird hauptsächlich als Spannungswandler benutzt, der eine an die primärseitigen Elektroden angelegte Niederspannung (Wechselspannung) in eine Hochspannung (Wechselspannung) transformiert, die an den sekundärseitigen Ausgangselektroden abgreifbar ist. Eine Schaltungsanordnung mit einem solchen piezoelektrischen Transformator zur Ansteuerung einer LCD ist beispielsweise aus der Veröffentlichung M. Sugimoto et al., SID 96 Digest, S. 757 (1996) bekannt.

Da ein piezoelektrischer Transformator auf der Primärseite mit Wechselspannung betrieben werden muß, ist bei bekannten Schaltungsanordnungen eine Ansteuerelektronik vorgesehen, die eine vorhandene Gleichspannung zunächst in eine Wechselspannung umwandelt, die dann der Primärseite des piezoelektrischen Transformators zugeführt wird. Diese Ansteuerelektronik benötigt allerdings verhältnismäßig viel Platz, verglichen mit dem geringen Platzbedarf des piezoelektrischen Transformators vor allem aufgrund dessen geringer Bauhöhe (verglichen mit konventionellen induktiven Transformatoren).

Aus der DE 31 23 104 A1 ist ein piezoelektrischer Transformator mit zwei primärseitig angebrachten Elektroden bekannt. Die primärseitige Eingangsoszillatorstufe umfasst einen Transistor-Kristalloszillator, wobei die positive Rückkopplung durch primärseitig angebrachte Rückkoppelelektroden erreicht wird.

Aus der JP 07/220888 ist ebenfalls ein piezoelektrischer Transformator mit zwei primärseitig angebrachten Elektroden bekannt. Der Transformator wird primärseitig von einem periodischen Spannungsinverters angesteuert.

Der Erfindung liegt deshalb die Aufgabe zugrunde, eine vereinfachte Schaltung mit einem piezoelektrischen Transformator sowie einen piezoelektrischen Transformator selbst anzugeben, der den genannten Nachteil vermeidet.

Diese Aufgabe wird erfindungsgemäß durch einen piezoelektrischen Transformator nach Anspruch 1 und eine Schaltungsanordnung mit einem solchen piezoelektrischen Transformator nach Anspruch 2 gelöst.

Das Schaltelement ist abhängig vom Ausdehnungszustand der Primärseite des Transformators entweder geschlossen oder geöffnet, wodurch die anliegende Gleichspannung periodisch unterbrochen wird. Eine eigene Steuerungselektronik für das Schaltelement ist nicht erforderlich.

Eine bevorzugte Ausgestaltung besteht darin, daß das Schaltelement in gedehntem Zustand der Primärseite geöffnet und in ungedehntem Zustand der Primärseite geschlossen ist. Wenn das Schaltelement geschlossen ist, liegt eine Gleichspannung an den Elektroden an, woraufhin sich die Primärseite aufgrund des piezoelektrischen Effekts ausdehnt. Wird ein bestimmter Ausdehnungsgrad überschritten, öffnet das erfindungsgemäß vorgesehene Schaltelement, so daß die Spannungszuführung unterbrochen ist. Daraufhin baut sich das an den Elektroden anliegende Spannungspotential wieder ab, wodurch sich auch die Primärseite des Transformators wieder zusammenzieht. Unterhalb des bestimmten Ausdehnungsgrades wird das Schaltelement wieder geschlossen und die Gleichspannung liegt wieder an, woraufhin der beschriebene Vorgang von vorne beginnt. Das Schaltelement wird also durch die Eigenbewegung der Primärseite des Transformators geöffnet und geschlossen, und die anliegende Gleichspannung wird dadurch an- und abgeschaltet, also in eine pulsierende Gleichspannung umgewandelt. Hinsichtlich der Übertragung der mechanischen Energie innerhalb des Transformators und der am Ausgang abgreifbaren Wechselspannung verhält sich der beschriebene piezoelektrische Transformator im wesentlichen wie bekannte piezoelektrische Transformatoren. Bei der erfindungsgemäßen Schaltungsanordnung kann allerdings die Ansteuerelektronik zur Erzeugung einer Wechselspannung zur Versorgung der primärseitigen Elektroden entfallen.

Die Ausgestaltung der Erfindung gemäß Anspruch 5 stellt eine einfach zu realisierende Lösungsmöglichkeit für das Schaltelement dar. Dieses kann beispielsweise so ausgestaltet sein, daß es in ausgedehntem Zustand geöffnet und im Normalzustand geschlossen ist. Zwischen den Schaltzuständen "geöffnet" und "geschlossen" kann ein fließender Übergang derart bestehen, daß die Leitfähigkeit mit zunehmender Ausdehnung des Schaltelements stetig abnimmt. Dabei erfolgt kein sprunghaftes An- und Abschalten der zugeführten Gleichspannung bei Ausdehnung oder Zusammenziehen des Schaltelements, sondern der durch das Schaltelement fließende Strom nimmt stetig ab bzw. zu.

Die Ausgestaltung gemäß Anspruch 6 stellt eine einfache und kompakte Lösung dar, bei der eine Elektrode auch gleichzeitig das Schaltelement bildet. Dies spart einerseits Kosten bei der Herstellung, insbesondere aufgrund des Wegfalls von Verfahrensschritten, und reduziert andererseits den Platzbedarf. Eine derartige Schicht, deren Leitfähigkeit mit zunehmender Ausdehnung abnimmt, wird auch als Perkolationsschicht bezeichnet,

Die Erfindung betrifft auch einen piezoelektrischen Transformator gemäß Anspruch 1, der primärseitig mit einer Gleichspannung betrieben werden kann.

Die erfindungsgemäße Schaltungsanordnung findet vor allem Verwendung zur Spannungsversorgung oder Ansteuerung von Lampen, insbesondere Fluoreszenz- oder Gasentladungslampen (z.B. kompakte Fluoreszenzlampen, Kaltkathoden-Fluoreszenzlampen, Hochdruckgasentladungslampen), Elektronenröhren oder zur Gittersteuerung bei Röntgenröhren. Darüber hinaus kann die erfindungsgemäße Schaltungsanordnung überall dort verwendet werden, wo miniaturisierte Spannungswandler mit nicht allzu großer Ausgangsleistung benötigt werden.

Die Erfindung wird nachfolgend anhand der Zeichnung näher erläutert. Es zeigen:
Fig. 1A bis 1C eine erfindungsgemäße Schaltungsanordnung zur Ansteuerung einer Lampe (in drei Ausdehnungszuständen des Transformators) und
Fig. 2A bis 2C einen erfindungsgemäßen piezoelektrischen Transformator mit einer Perkolationsschicht (in drei Ausdehnungszuständen).

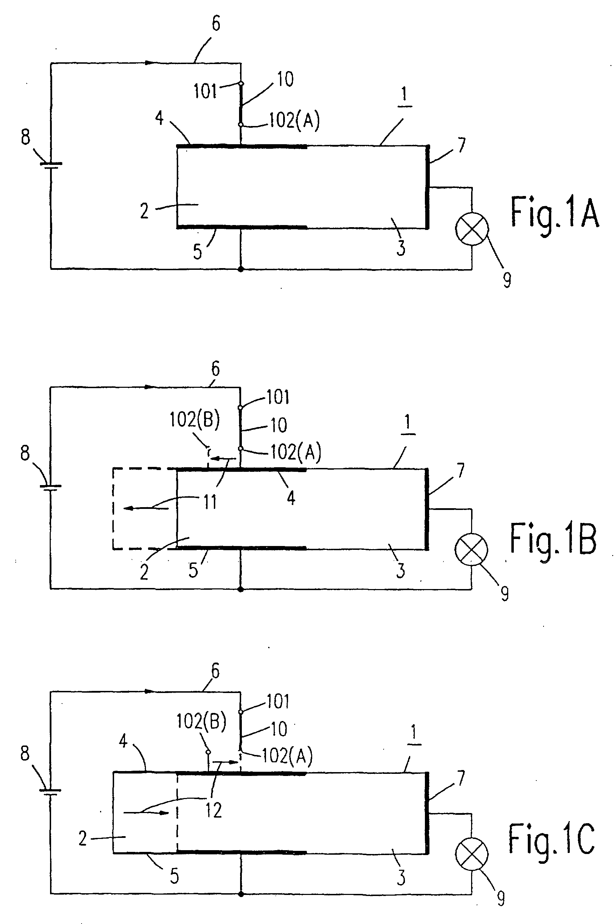

Die Fig. 1A bis 1C zeigen eine erfindungsgemäße Schaltungsanordnung zur Versorgung einer Lampe 9 mit einer Wechselspannung, wobei der piezoelektrische Transformator 1 in unterschiedlichen Ausdehnungszuständen gezeigt ist. Der piezoelektrische Transformator 1, der hier als quaderförmiger piezokeramischer Block und als Rosen-Typ-Transformator ausgestaltet ist, ist in Primärseite 2 und Sekundärseite 3 unterteilt. Zwei auf der Oberfläche aufgebrachte Elektroden 4, 5 bilden die Primärelektroden, die an eine Gleichspannungsquelle, hier eine Batterie 8, angeschlossen sind. An einer seitlich an der Sekundärseite 3 angebrachten Sekundärelektrode 7 und der als Bezugselektrode dienenden Primärelektrode 5 kann eine hochfrequente Wechselspannung abgegriffen werden zur Versorgung der Lampe 9. Die Polarisationsrichtung der Piezokeramik auf der Primärseite 2 und der Sekundärseite 3 liegt parallel zu den Primärelektroden 4, 5 und parallel zur Zeichenebene.

In der Versorgungsleitung 6 von der Batterie 8 zur Primärelektrode 4 ist ein Schaltelement 10 mit zwei Schaltkontakten 101, 102 vorgesehen. In Fig. 1A befindet sich die Primärseite 2 in ungedehntem Ruhezustand, in dem auch das Schaltelement 10 geschlossen ist und der Schaltkontakt 102 in der Ausgangslage (A) ist. Diese Ruhelage nimmt die Primärseite 2 ein, wenn zwischen den Primärelektroden 4, 5 kein oder nur ein geringes Spannungspotential anliegt. Bei Anlegen einer Gleichspannung aus der Batterie 8 fließt ein Strom durch die Zuführung 6 und den Schalter 10, so daß sich zwischen den Elektroden 4, 5 ein Spannungspotential aufbaut. Dieses führt aufgrund des piezoelektrischen Effekts zu einer Ausdehnung der Primärseite 2 in der durch Pfeile 11 angedeuteten Richtung. Da der Schaltkontakt 102 fest mit der Elektrode 4 verbunden ist, die wiederum fest auf der Oberfläche der Primärseite 2 angebracht ist, bewegt sich auch der Schaltkontakt 102 von der Position A in die Position B (siehe Fig. 1B). Dadurch wird das Schaltelement 10 geöffnet, so daß die Stromzufuhr von der Batterie 8 an die Elektrode 4 unterbrochen wird.

Nach der Unterbrechung der Stromzufuhr baut sich das zwischen den Elektroden 4, 5 anliegende Spannungspotential wieder ab, woraufhin sich die Primärseite 2 wieder zusammenzieht und in Richtung der Pfeile 12 und in den Ruhezustand zurückkehrt. Dadurch kehrt auch der Schaltkontakt 102 wieder in die mit A bezeichnete Lage zurück, und das Schaltelement 10 wird wieder geschlossen (siehe Fig. 1C). Nun fließt erneut Strom durch das Schaltelement 10 und es kann sich wieder ein Spannungspotential zwischen den Elektroden 4, 5 aufbauen, so daß der beschriebene Vorgang erneut von vorne beginnt.

Bei der beschriebenen Schaltungsanordnung kann ebenso wie bei der bekannten Schaltungsanordnung eine hochfrequente Wechselspannung an den Elektroden 7 und 5 abgegriffen werden. Die interne Übertragung mechanischer Energie von der Primärseite 2 auf die Sekundärseite 3 erfolgt bei dem gezeigten piezoelektrischen Transformator in der gleichen Weise wie bei bekannten piezoelektrischen Transformatoren dadurch, daß die Primärseite 2 in Schwingung (bei einer Resonanzfrequenz) versetzt wird, welche an die Sekundärseite 3 ankoppelt und diese ebenfalls in einen Schwingungsmodus versetzt. Die Höhe der abgreifbaren Ausgangsspannung hängt von der Größe der Batteriespannung und dem gewählten Transformationsfaktor (der auch vom internen Aufbau des piezoelektrischen Transformators abhängt, z.B. Ausgestaltung der Sekundärseite 3 mit mehreren durch jeweils eine Elektrode getrennte piezoelektrische Schichten) ab.

Bei einer Ausgestaltung, bei der nicht die Elektrode 5 als gemeinsame Bezugselektrode für Primär- und Sekundärseite dient, sondern die Sekundärseite 3 eine eigene zweite Elektrode als Bezugselektrode aufweist, kann das Schaltelement auch in der Zuleitung von der Batterie 8 zur Elektrode 5 (alleine oder zusätzlich zum gezeigte Schaltelement 10) vorgesehen sein.

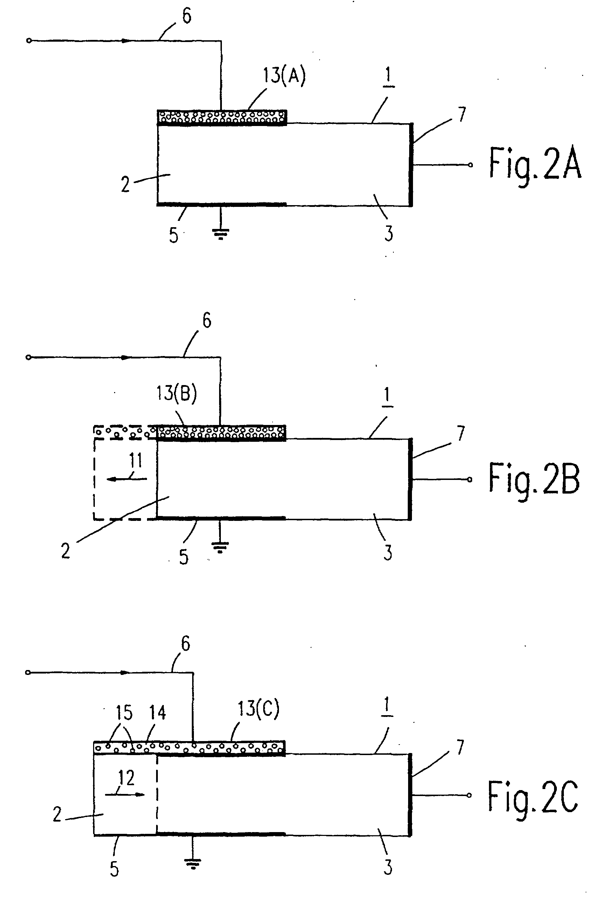

In den Fig. 2A bis 2C ist eine weitere Ausgestaltung der Erfindung gezeigt, wobei der piezoelektrische Transformator 1 wiederum in unterschiedlichen Ausdehnungszuständen dargestellt ist. Die in Fig. 1 gezeigte Batterie 8 und die Lampe 9 sind hier der Übersichtlichkeit halber weggelassen. Die obere Primärelektrode (4 in Fig. 1), an die die Gleichspannungszuleitung 6 angeschlossen ist, ist hier als dünne Perkolationsschicht 13 ausgestaltet. Diese wirkt gleichzeitig als Schaltelement, das durch die Ausdehnung der Primärseite 2 geschlossen und geöffnet werden kann, was nachfolgend erläutert werden soll.

Die Perkolationsschicht ist als Komposit aus elastisch deformierbarem Material ausgebildet. Dieses Komposit besteht aus einer elektrisch isolierenden Kunststoffmatrix 14 (siehe Fig. 2C), z.B. aus einem Polymer, Polyolefin oder auch SiO₂, mit eingelagerten elektrisch leitfähigen Partikeln 15, die beispielsweise aus Metall, oxydisch leitendem Material oder auch aus Graphit bestehen können. Der Anteil leitender Partikel 15 in der Perkolationsschicht 13 liegt je nach Form und Zusammensetzung vorzugsweise zwischen 30% und 60%.

In Fig. 2A sind die Primärseite 2 und die Perkolationsschicht 13 in ungedehntem Ruhezustand gezeigt, in dem die Perkolationsschicht 13 als geschlossener Schalter wirkt. In diesem Zustand berühren sich die leitfähigen Partikel 15 oder sind so eng benachbart, daß ein Strom, der im wesentlichen durch Tunnelströme gebildet wird, durch die Perkolationsschicht 13 fließen kann. Bei Anliegen einer Gleichspannung an die Primärelektroden 13, 5 baut sich zwischen diesen ein Spannungspotential auf, das zu einer Ausdehnung der Primärseite 2 und gleichzeitig der Perkolationsschicht 13, die auf der Primärseite 2 fest aufgebracht ist, in Richtung des Pfeiles 11 führt (siehe Fig. 2B). Dadurch verlieren die leitenden Partikel 15 ihren Kontakt und werden so weit auseinander bewegt, daß kein Stromfluß mehr durch die Perkolationsschicht 13 möglich ist. Der Widerstand der Perkolationsschicht steigt dabei vom ungedehnten Ruhezustand (Fig. 2A) bis zum maximal gedehnten Zustand (Fig. 2c) stetig an, so daß der durch die Perkolationsschicht 13 fließende Strom stetig abnimmt, bis überhaupt kein Stromfluß mehr möglich ist. Das zwischen der Perkolationsschicht 13 und der Elektrode 5 aufgebaute Spannungspotential baut sich daraufhin wieder ab, wonach auch die Primärseite 2 und die Perkolationsschicht 13 wieder in den ungedehnten Ruhezustand zurückkehren und auch die Perkolationsschicht 13 wieder leitend wird. Der beschriebene Vorgang beginnt nun wieder von vorne.

Die Perkolationsschicht ist so dünn, daß sie die elastischen Eigenschaften des piezoelektrischen Transformators 1 nicht beeinflußt. Die Frequenz des beschriebenen periodischen Vorgang ist nur durch die elektromechanischen Eigenschaften des Transformators selbst bestimmt, d.h. es stellt sich eine von den dessen charakteristischen Eigenfrequenzen ein, insbesondere eine Resonanzfrequenz.

Es ist auch denkbar, das Schaltelement so auszugestalten, daß das bekannte Prinzip des Wagnerschen Hammers ausgenutzt wird, bei dem ein Unterbrecherkontakt wechselweise geöffnet wird (durch das Magnetfeld eines Elektromagneten, wenn ein Strom fließt durch den Elektromagneten und den Unterbrecherkontakt) und geschlossen wird (z.B. durch eine Feder, wenn kein Strom fließt).

## Patentansprüche

1. Piezoelektrischer Transformator (1) mit zwei an einer Primärseite (2) des Transformators (1) angeordneten Elektroden (4, 5, 13),
**dadurch gekennzeichnet, dass** wenigstens eine der Elektroden (4, 13) wenigstens einen Schaltkontakt (102, 15) eines Schaltelements (10) aufweist, wobei die Schaltzustände vom Ausdehnungszustand der Primärseite (2) des Transformators (1) abhängig sind.

2. Schaltungsanordnung mit einem piezoelektrischen Transformator (1) nach Anspruch 1,
**dadurch gekennzeichnet, dass** an die Elektroden (4, 5, 13) eine Gleichspannungsquelle (8) angeschlossen ist und dass das Schaltelement (10) zum Unterbrechen der Spannungszuführung zu der wenigstens den Schaltkontakt (102, 15) aufweisenden Elektrode (4, 5, 13) vorgesehen ist.

3. Schaltungsanordnung nach Anspruch 2,
**dadurch gekennzeichnet, dass** das Schaltelement (10) derart ausgestaltet ist, dass es in gedehntem Zustand der Primärseite (2) geöffnet und in ungedehntem Zustand der Primärseite (2) geschlossen ist.

4. Schaltungsanordnung nach Anspruch 2,
**dadurch gekennzeichnet, dass** ein Schaltkontakt (101) des Schaltelements (10) in der Zuführung (6) zu der wenigstens den Schaltkontakt (102, 15) aufweisenden Elektrode (4, 5, 13) vorgesehen ist.

5. Schaltungsanordnung nach Anspruch 2,
**dadurch gekennzeichnet, dass** das Schaltelement (10) dehnbar und unmittelbar mit der wenigstens den Schaltkontakt (102, 15) aufweisenden Elektrode (4, 5, 13) oder mit der Primärseite (2) derart verbunden ist, dass der Ausdehnungszustand des Schaltelements (10) abhängig ist vom Ausdehnungszustand der Primärseite (2) des Transformators (1), und dass das Schaltelement (10) derart ausgebildet ist, dass dessen Leitfähigkeit von seinem Ausdehnungszustand abhängt derart, dass die Leitfähigkeit mit zunehmender Ausdehnung abnimmt.

6. Schaltungsanordnung nach Anspruch 2,
**dadurch gekennzeichnet, dass** die wenigstens den Schaltkontakt (102, 15) aufweisende Elektrode (4, 5, 13) selbst als Schaltelement (10) ausgebildet ist.

7. Schaltungsanordnung nach Anspruch 6,
**dadurch gekennzeichnet, dass** die als Schaltelement (10) ausgebildete Elektrode (4, 5, 13) durch eine Schichtelektrode (13) gebildet ist, welche aus einem elektrisch isolierenden, ausdehnungsfähigen Material (14) mit eingebrachten elektrisch leitfähigen Partikeln (15) besteht.

8. Verwendung der Schaltungsanordnung nach Anspruch 2 zur Spannungsversorgung oder Steuerung von Lampen (9), insbesondere Fluoreszenz- oder Gasentladungslampen, Elektronenröhren oder Röntgenröhren.

## Claims

1. A piezoelectric transformer (1) having two electrodes (4, 5, 13) arranged on the primary side (2) of the transformer (1), **characterized in that** at least one of the electrodes (4, 13) has at least one contact (102, 15) of a switching element (10), the switching states depending on the state of expansion of the primary side (2) of the transformer (1).

2. A circuit arrangement comprising a piezoelectric transformer (1) as claimed in claim 1, **characterized in that** a DC voltage source (8) is connected to the electrodes (4, 5, 13) and **in that** the switching element (10) is provided for interrupting the power supply to the electrode (4, 5, 13) comprising at least the switching contact (102, 15).

3. A circuit arrangement as claimed in claim 2, **characterized in that** the switching device (10) is arranged so that it is open in the expanded state of the primary side (2) and closed in the non-expanded state of the primary side (2).

4. A circuit arrangement as claimed in claim 2, **characterized in that** a switching contact (101) of the switching device (10) is included in the supply line (6) to the electrode (4, 5, 13) comprising at least the switching contact (102, 15).

5. A circuit arrangement as claimed in claim 2, **characterized in that** the switching device (10) can be expanded and is directly connected to the electrode (4, 5, 13) comprising at least the switching contact (102, 15), or to the primary side (2), in such a way that the state of expansion of the switching device (10) depends on the state of expansion of the primary side (2) of the transformer (I), and **in that** the switching device (13) is arranged so that its conductivity depends on its state of expansion so that the conductivity decreases as expansion increases.

6. A circuit arrangement as claimed in claim 2, **characterized in that** the electrode (4, 5, 13) which comprises at least the switching contact (102, 15) is arranged as a switching element (10) itself.

7. A circuit arrangement as claimed in claim 6, **characterized in that** the electrode (4, 5, 13) arranged as a switching device (10) is formed by a percolation layer electrode (13) which consists of an electrically insulating material (14) which can expand and has deposited conductive particles (15).

8. Use of the circuit arrangement as claimed in claim 2, for the power supply or control of lamps (9), more particularly, fluorescent or gas-discharge lamps, electron tubes or X-ray tubes.

## Revendications

1. Transformateur piézoélectrique (1) avec deux électrodes (4, 5, 13) disposées côté primaire (2) du transformateur (1), caractérisé en ce qu'au moins une des électrodes (4, 13) présente au moins un contact de commutation (102, 15) d'un élément commutateur (10), les états commutateurs dépendant de l'état d'extension du côté primaire (2) du transformateur (1).

2. Circuit avec un transformateur piézoélectrique (1) selon la revendication 1, **caractérisé en ce qu'**une source de tension continue (8) est raccordée aux électrodes (4, 5, 13) et que l'élément de commutation (10) est prévu pour l'interruption de l'alimentation de tension vers l'électrode (4, 5, 13) présentant au moins le contact de commutation (102, 15).

3. Circuit selon la revendication 2, **caractérisé en ce que** l'élément de commutation (10) est conçu de telle sorte qu'il soit ouvert à l'état étendu du côté primaire (2) et fermé à l'état non étendu du côté primaire (2).

4. Circuit selon la revendication 2, **caractérisé en ce que** un contact de commutation (101) de l'élément de commutation (10) est prévu dans ladite alimentation (6) vers l'électrode (4, 5, 13) présentant au moins le contact de commutation (102, 15).

5. Circuit selon la revendication 2, **caractérisé en ce que** l'élément de commutation (10) est extensible et relié directement avec l'électrode (4, 5, 13) présentant au moins le contact de commutation (102, 15) ou avec le côté primaire (2) de telle sorte que l'état d'extension de l'élément de commutation (10) dépende de l'état d'extension du côté primaire (2) du transformateur (1) et que l'élément de commutation (10) est conçu de telle sorte que sa conductibilité dépende de son état d'extension de telle sorte que sa conductibilité diminue avec l'extension croissante.

6. Circuit selon la revendication 2, **caractérisé en ce que** l'électrode (4, 5, 13) présentant au moins le contact de commutation (102, 15) est elle-même conçue comme un élément de commutation (10).

7. Circuit selon la revendication 6, **caractérisé en ce que** l'électrode (4, 5, 13) conçue comme un élément de commutation (10) est formée par une électrode de couche (13) qui se compose d'un matériau (14) extensible isolant électriquement avec des particules (15) électriquement conductrices incluses.

8. Mise en oeuvre du circuit selon la revendication 2 pour l'alimentation en tension ou la commande de lampes (9), en particulier de lampes à fluorescence ou à décharge de gaz, de tube à électrons ou à rayons x.
